# EUROPÄISCHE PATENTSCHRIFT

(11) **EP 1 154 914 B1**
(45) Veröffentlichungstag und Bekanntmachung des Hinweises auf die Patenterteilung: **23.10.2002**
(21) Anmeldenummer: 00908963.2
(22) Anmeldetag: 01.02.2000
(51) Int. Cl.: B60R 16/02

(54) **STEUERGERÄT FÜR EIN KRAFTFAHRZEUG**
CONTROL APPARATUS FOR AN AUTOMOBILE
APPAREIL DE COMMANDE POUR UN VEHICULE

(30) Priorität: 24.02.1999 DE 19907949
(43) Veröffentlichungstag der Anmeldung: 21.11.2001
(73) Patentinhaber: SIEMENS AKTIENGESELLSCHAFT, 80333 München (DE)
(72) Erfinder: LOIBL, Josef, D-94209 Regen (DE); SCHEUERER, Ulf, D-93047 Regensburg (DE)
(86) Internationale Anmeldenummer: DE0000280
(87) Internationale Veröffentlichungsnummer: WO00050263

(56) Entgegenhaltungen:
- DE-A- 4 228 818
- DE-A- 4 340 280
- DE-A- 4 437 664
- DE-A- 19 511 487
- DE-A- 19 515 622
- DE-C- 19 712 842
- DE-C- 19 734 032

## Beschreibung

Die Erfindung betrifft ein Steuergerät für ein Kraftfahrzeug nach dem Oberbegriff des Anspruchs 1.

In jüngster Zeit besteht vermehrt die Tendenz, Motor- und Getriebesteuergeräte in die zu steuernde Kraftfahrzeug-Baugruppe (d.h. Motor oder Getriebe) zu integrieren. Dieses Konzept weist ein beträchtliches Kosteneinsparungspotential im Vergleich zu der konventionellen Verwendung externer Steuergeräte auf. Technologische Schwierigkeiten ergeben sich infolge erhöhter Systemanforderungen in bezug auf Dichtigkeit gegenüber Umgebungsmedien (Öl, Benzin, Wasser), Funktionsfähigkeit über einen breiten Temperaturbereich (etwa -40°C bis 150°C) und Vibrationsfestigkeit (bis zu etwa 40 g).

Ein Steuergerät nach dem Oberbegriff des Anspruchs 1 ist in der deutschen Patentschrift DE 197 12 842 C1 beschrieben. Bei diesem Gerät wird die elektrische Verbindung zwischen der Steuerelektronik und den zu steuernden Elektrobauteilen durch eine flexible Leiterplatte realisiert. Es hat sich gezeigt, daß es gelegentlich Schwierigkeiten bereiten kann, einen definierten Verlauf der flexiblen Leiterplatte außerhalb des Steuergerätes zu gewährleisten.

In der deutschen Patentanmeldung DE 195 15 622 A1 ist ein Getriebesteuergerät beschrieben, bei dem die elektrische Kontaktierung der von dem Steuergerät angesteuerten Elektrobauteile über ein Stanzgitter erfolgt, das in dem Kunststoff-Deckenteil des Steuergerätes eingespritzt ist. Diese Lösung ermöglicht eine mechanisch stabile und elektrisch sichere Kontaktierung der Elektrobauteile, sie ist jedoch konstruktiv relativ aufwendig.

Ein weiteres gemäß den Merkmalen des Oberbegriffs des Anspruchs 1 gebildetes Kfz-Steuergerät ist in der deutschen Patentschrift DE 197 34 032 C1 beschrieben.

In der deutschen Offenlegungsschrift DE 42 28 818 A1 ist ein Steuergerät für Kraftfahrzeuge beschrieben, bei welchem eine flexible Leiterplatte zwischen einer Bodenplatte und einem inneren Dichtrahmen abdichtend durchgeführt und zu einem Gehäusestecker hingeführt ist. Die elektrische Anbindung des Kfz-Steuergeräts an externe Elektrobauteile erfolgt über den Gehäusestecker.

In der deutschen Offenlegungsschrift DE 44 37 664 A1 ist ein Kfz-Steuergerät beschrieben, dessen Gehäusekörper durch eine aushärtbare Schaumstoffmasse realisiert ist. Mehrere flexible Leiterplatten ragen aus dem Gehäusekörper hinaus und realisieren Verbindungen zu in der Umgebung liegenden Elektrobauteilen.

Der Erfindung liegt die Aufgabe zugrunde, ein Steuergerät für ein Kraftfahrzeug zu schaffen, das eine kostengünstig realisierbare und mechanisch sichere elektrische Anbindung von externen Elektrobauteilen (Steckern, Aktoren, Sensoren) an die Steuerelektronik des Steuergeräts ermöglicht.

Die der Erfindung zugrundeliegende Aufgabenstellung wird durch die Merkmale des Anspruchs 1 gelöst.

Durch die die Bodenplatte flächig fortsetzende Leiterplatten-Trägerstruktur wird ein entsprechend den baulichen Gegebenheiten ausreichend lagedefinierter Verlauf der flexiblen Leiterplatte außerhalb des Steuergeräts gewährleistet. Dadurch können mechanische Beschädigungen der flexiblen Leiterplatte, wie sie beispielsweise infolge von Vibrationen durch Reibung der Leiterplatte an benachbarten Wandungen oder Motor/Getriebe-Komponenten entstehen können, sicher vermieden werden.

Die Verwendung einer flexiblen Leiterplatte zur Stromverteilung ermöglicht im Vergleich zu konstruktiv aufwendigeren Lösungen (Verkabelungen mit Steckverbindern, Gehäuseteil-integrierte Stanzgitter usw.) deutliche Kostenvorteile.

Vorzugsweise ist die Leiterplatten-Trägerstruktur so dimensioniert, daß ihre Außenkontur im wesentlichen allseitig die Außenkontur der flexiblen Leiterplatte umgibt. Die flexible Leiterplatte ist dann ganzflächig von der Leiterplatten-Trägerstruktur kaschiert und kann von dieser praktisch an jeder Stelle lagemäßig kontrolliert werden.

Die Leiterplatten-Trägerstruktur kann vorzugsweise abtrennbare Abschnitte und/oder in verschiedenen Ebenen verlaufende Abschnitte umfassen. Dadurch wird ermöglicht, daß die spezifischen Vorzüge einer flexiblen Leiterplatte hinsichtlich des Ausgleichs von Montage- und Bauteiltoleranzen weiterhin genutzt werden können.

Grundsätzlich kann die flexible Leiterplatte allein durch Anlage an die Leiterplatten-Trägerstruktur in der gewünschten lagedefinierten Position gehalten werden. Eine besonders vorteilhafte Variante der Erfindung kennzeichnet sich jedoch dadurch, daß die flexible Leiterplatte an speziell vorgebbaren Positionen an der Leiterplatten-Trägerstruktur lokal fixiert ist. Dadurch wird eine ortsgenaue Positionierung und Ausrichtung der flexiblen Leiterplatte auf der Leiterplatten-Trägerstruktur ermöglicht, welche die Montage des Verbunds aus Leiterplatten-Trägerstruktur und Leiterplatte in das Getriebe/den Motor erleichtert. Durch die Wahl geeigneter Fixier-Positionen kann gewährleistet werden, daß es auch bei sehr hohen Temperaturschwankungen nicht zu einer Beschädigung der Leiterplatte infolge unterschiedlicher Materialausdehnungen kommen kann.

Die vorzugsweise metallische Bodenplatte kann in einer Vertiefung oder Öffnung der vorzugsweise aus Kunststoff bestehenden Leiterplatten-Trägerstruktur verankert sein.

Weitere vorteilhafte Ausgestaltungen der Erfindung sind in den Unteransprüchen beschrieben.

Die Erfindung wird nachfolgend in beispielhafter Weise unter Bezugnahme auf die Zeichnung beschrieben; in dieser zeigt:
- Fig. 1: eine schematische Querschnittdarstellung eines erfindungsgemäßen Steuergeräts entlang der Linie I-I in Fig. 2;
- Fig. 2: eine schematische Darstellung des Steuergeräts aus Fig. 1 in Draufsicht ohne Deckel;
- Fig. 3: eine Perspektivansicht einer Leiterplatten-Trägerstruktur mit integrierter Bodenplatte;

Die Leiterplatten-Trägerstruktur 9 kann in Form einer Kunststoffplatte realisiert sein. Die metallische Bodenplatte 2 kann entweder direkt in die Leiterplatten-Trägerstruktur 9 (Kunststoffplatte) eingespritzt sein oder kann nachträglich durch eine Schnappverbindung oder dergleichen in einer zentralen Öffnung oder Vertiefung der Leiterplatten-Trägerstruktur 9 verankert werden.

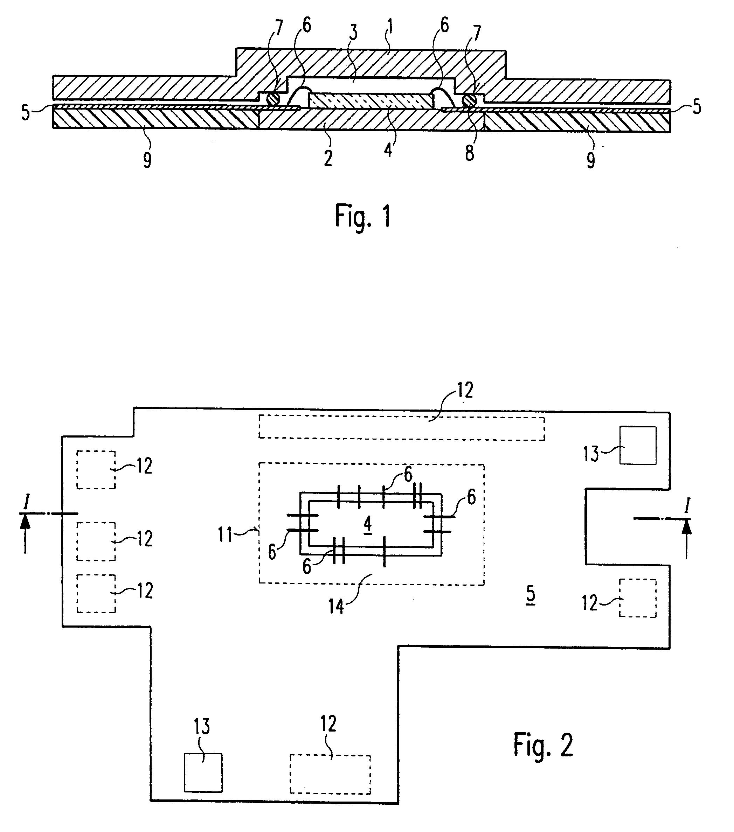

Fig. 2 zeigt das Steuergerät bei abgenommenem Gehäusedeckel 1 (ohne Ringdichtung 8) in Draufsicht. Wie bereits erwähnt, weist die flexible Leiterplatte 5 eine zentrale Ausstanzung 10 auf, durch die der Schaltungsträger 4 hindurchragt.

Eine Konturlinie 11 deutet den Umfangsverlauf der metallischen Bodenplatte 2 an.

Aus Gründen der Dichtigkeit ist die flexible Leiterplatte 5 ganzflächig (d.h. über den gesamten Bereich 14 zwischen der Konturlinie 11 und der Ausstanzung 10) durch Klebung (Laminierung) an der Bodenplatte 2 befestigt. Im Gegensatz dazu ist die flexible Leiterplatte 5 an der Leiterplatten-Trägerstruktur 9 (d.h. im Bereich außerhalb der Konturlinie 11) lediglich partiell, nämlich an vorgegebenen Haftzonen 12, durch geeignete Maßnahmen wie beispielsweise Klebung (Laminierung) befestigt. Die nur partielle Fixierung gewährleistet, daß Temperaturschwankungen trotz unterschiedlichem Ausdehnungsverhalten der Bodenplatte 2 und der Leiter-platten-Trägerstruktur 9 nicht zu einer Beschädigung der flexiblen Leiterplatte 5 führen.

Die Haftzonen 12 befinden sich vorzugsweise in Bereichen, die für eine spätere elektrische Anpreßkontaktierung von Elektrobauteilen vorgesehen sind. Andere Bereiche 13 der flexiblen Leiterplatte 5 dürfen aufgrund eines dort benötigten Toleranzausgleichs nicht an der Leiterplatten-Trägerstruktur 9 fixiert sein. Es kann sich dabei um Bereiche 13 handeln, an denen ein Getriebestecker angebracht oder ein in unterschiedlichen Montagelagen befestigbarer oder als Bewegungsteil ausgelegter Sensor/Aktor angeschlossen werden soll.

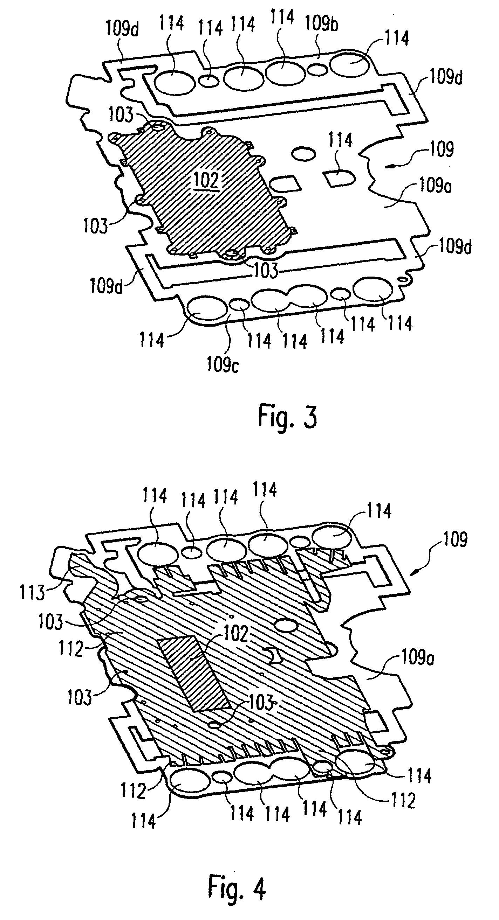

Fig. 3 zeigt eine Leiterplatten-Trägerstruktur 109 mit integrierter Bodenplatte 102 in perspektivischer Ansicht. Die metallische Bodenplatte 102 weist in ihrem Randbereich Montagelöcher 103 auf, über welche die Bodenplatte 102 mittels Schraubverbindungen oder anderer geeigneter Befestigungselemente an dem Gehäusedeckel 1 festlegbar ist.

Die Leiterplatten-Trägerstruktur 109 weist einen Zentralabschnitt 109a und zwei Seitensegmente 109b und 109c auf. Die Seitensegmente 109b, 109c sind über Stege 109d mit dem Zentralabschnitt 109a verbunden. Falls aus baulichen Gründen ein Verlauf der flexiblen Leiterplatte 105 (siehe Fig. 4) auf verschiedenen Ebenen gefordert ist, können die Seitensegmente 109b, 109c aufgrund der Flexibilität der Stege 109d gegenüber dem Zentralabschnitt 109a in der Höhe verändert oder verkippt werden. Die Stege 109d können auch stufenförmig ausgebildet sein, so daß der Zentralabschnitt 109a und die Seitensegmente 109b, 109c bereits konstruktiv in unterschiedlichen Ebenen liegen. Eine dritte Möglichkeit besteht darin, in den Stegen 109d querverlaufende Sollbruchlinien vorzusehen. An diesen Sollbruchlinien können die Stege 109d dann beim Einbau des Steuergeräts in das Getriebe/den Motor getrennt werden, so daß die Seitensegmente 109b, 109c nur noch über die flexible Leiterplatte 105 mit dem Zentralabschnitt 109a verbunden sind.

In den Seitensegmenten 109b, 109c und in dem Zentralabschnitt 109a können Öffnungen 114 für die zu kontaktierenden Elektrobauteile vorgesehen sein.

Fig. 4 zeigt den in Fig. 3 dargestellten Verbund aus Bodenplatte 102 und Leiterplatten-Trägerstruktur 109 mit aufliegender flexibler Leiterplatte 105. Haftzonen 112 (gemäß 12) befinden sich oberhalb der Bodenplatte 102 sowie in Randbereichen der Öffnungen 114. In einem Bereich 113, an dem ein Steckerteil angebracht werden soll, ist die Leiterplatte 105 nicht an der Leiterplatten-Trägerstruktur 109 fixiert.

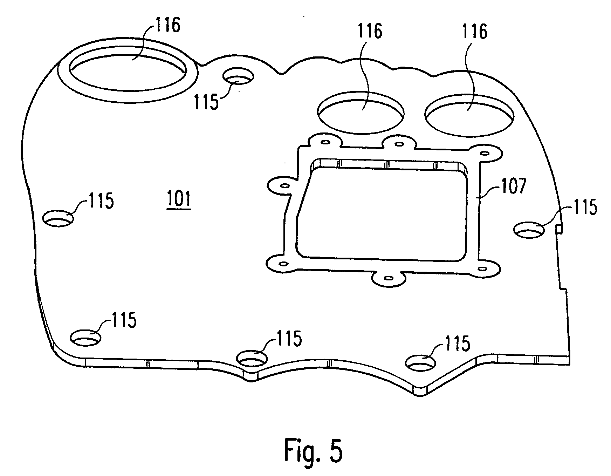

Fig. 5 zeigt in beispielhafter Weise einen Gehäusedeckel 101 eines erfindungsgemäßen Steuergeräts. Der Gehäusedeckel 101 ist über Bohrungen 115 im Innenraum eines Getriebe-/Motorgehäuses befestigbar und bildet den Träger des Steuergeräts. Die Dichtfläche 107 umgibt die den Hohlraum 3 begrenzende haubenförmige Ausnehmung des Gehäusedeckels 101.

In dem Gehäusedeckel 101 sind Montagelöcher 116 vorgesehen, über die elektrisch zu kontaktierende Elektrobauteile am Gehäusedeckel 101 befestigt sind. Im zusammengesetzten Zustand sind die Öffnungen 114 mit den Montagelöchern 116 ausgerichtet. Die flexible Leiterplatte 5, 105 kann beidseitig vollständig von dem Gehäusedeckel 1, 101 und der Leiterplatten-Trägerstruktur 9, 109 überdeckt sein.

## Patentansprüche

1. Steuergerät für ein Kraftfahrzeug, das aufweist:
- eine Bodenplatte (2, 102),
- einen mit der Bodenplatte (2, 102) öldicht gekoppelten Gehäusedeckel (1, 101), und
- eine auf der Bodenplatte (2, 102) verlaufende flexible Leiterplatte (5, 105), die
- - eine in dem aus Gehäusedeckel (1, 101) und Bodenplatte (2, 102) gebildeten Hohlraum (3) untergebrachte elektronische Schaltung (4) elektrisch kontaktiert,
- - zwischen dem Gehäusedeckel (1, 101) und der Bodenplatte aus (2, 102) dem Hohlraum (3) herausgeführt ist, und
- - sich zu außerhalb des Hohlraums (3) angeordneten Elektrobauteilen erstreckt und diese elektrisch mit der elektronischen Schaltung (4) verbindet,
**gekennzeichnet durch**
- eine die Bodenplatte (2, 102) flächig fortsetzende Leiterplatten-Trägerstruktur (9, 109) zur gezielten Beeinflussung der Lage der flexiblen Leiterplatte (5, 105) zwischen der Außenkontur (11) der Bodenplatte (2, 102) und den Elektrobauteilen.

2. Steuergerät nach Anspruch 1,
**dadurch gekennzeichnet,**
**daß** die Leiterplatten-Trägerstruktur (9, 109) so dimensioniert ist, daß ihre Außenkontur die Außenkontur der flexiblen Leiterplatte (5, 105) im wesentlichen allseitig umgibt.

3. Steuergerät nach Anspruch 1 oder 2,
**dadurch gekennzeichnet,**
**daß** die Leiterplatten-Trägerstruktur (9, 109) abtrennbare Abschnitte und/oder in verschiedenen Ebenen verlaufende Abschnitte (109a, 109b, 109c) umfaßt.

4. Steuergerät nach einem der vorhergehenden Ansprüche,
**dadurch gekennzeichnet,**
**daß** die Leiterplatten-Trägerstruktur (9, 109) mit wenigstens einer Ausnehmung (114) zur Aufnahme eines Elektrobauteils versehen ist.

5. Steuergerät nach einem der vorhergehenden Ansprüche,
**dadurch gekennzeichnet,**
**daß** die flexible Leiterplatte (5, 105) an speziell vorgebbaren Positionen an der Leiterplatten-Trägerstruktur (9, 109) fixiert ist.

6. Steuergerät nach einem der vorhergehenden Ansprüche,
**dadurch gekennzeichnet,**
**daß** die Bodenplatte (2, 102) aus Metall besteht und in einer Vertiefung oder Öffnung der Leiterplatten-Trägerstruktur (9, 109) verankert ist.

7. Steuergerät nach Anspruch 6,
**dadurch gekennzeichnet,**
**daß** die metallische Bodenplatte (2, 102) direkt in die aus Kunststoff bestehende Leiterplatten-Trägerstruktur (9, 109) eingespritzt ist.

## Claims

1. Control unit for a motor vehicle, which has
- a base plate (2, 102),
- a housing cover (1, 101) which is secured to the base plate (2, 102) with an oil-tight seal, and
- a flexible printed circuit board (5, 105) situated on the base plate (2, 102), which
- - makes electrical contact with an electronic circuit (4) housed in the hollow space (3) formed by the housing cover (1, 101) and the base plate (2, 102),
- - is brought out of the hollow area (3) between the housing cover (1, 101) and the base plate (2, 102), and
- - extends to electrical components located outside the hollow area (3) and connects these electrically to the electronic circuit (4),
**characterised by**
- a printed circuit board support structure (9, 109) continuing the area of the base plate (2, 102) for specifically influencing the position of the flexible printed circuit board (5, 105) between the outer contour (11) of the base plate (2, 102) and the electrical components.

2. Control unit according to Claim 1, **characterised in that** the printed circuit board support structure (9, 109) is dimensioned such that its outer contour essentially surrounds the outer contour of the flexible printed circuit board (5, 105) on all sides.

3. Control unit according to Claim 1 or 2, **characterised in that** the printed circuit board support structure (9, 109) comprises detachable sections and/or sections (109a, 109b, 109c) situated in different planes.

4. Control unit according to one of the preceding claims, **characterised in that** the printed circuit board support structure (9, 109) is provided with at least one opening (114) for accommodating an electrical component.

5. Control unit according to one of the preceding claims, **characterised in that** the flexible printed circuit board (5, 105) is fixed to the printed circuit board support structure (9, 109) at specially pre-definable positions.

6. Control unit according to one of the preceding claims, **characterised in that** the base plate (2, 102) is made of metal and is anchored in a recess or opening in the printed circuit board support structure (9, 109).

7. Control unit according to Claim 6, **characterised in that** the metallic base plate (2, 102) is spray-moulded directly into the printed circuit board support structure (9, 109) which is made of plastic.

## Revendications

1. Appareil de commande pour un véhicule à moteur, qui présente:
- une plaque de fond (2, 102),
- un couvercle de boîtier (1, 101) couplé à la plaque de fond (2, 102) de façon étanche à l'huile,
- une plaquette de circuits imprimés flexible (5, 105) s'étendant sur la plaque de fond (2, 102), qui
- - est en contact électrique avec un circuit électronique (4) installé dans l'espace creux (3) formé par le couvercle de boîtier (1, 101) et la plaque de fond (2, 102),
- - est menée hors de l'espace creux (3) entre le couvercle de boîtier (1, 101) et la plaque de fond (2, 102), et
- - s'étend jusqu'à des composants électriques disposés à l'extérieur de l'espace creux (3) et connecte électriquement ceux-ci électriquement au circuit électronique (4),
**caractérisé par**
- une structure de support (9, 109) de la plaquette de circuits imprimés prolongeant à plat la plaque de fond (2, 102) pour agir de façon adéquate sur la position de la plaquette de circuits imprimés flexible (5, 105) entre le contour extérieur (11) de la plaque de fond (2, 102) et les composants électriques.

2. Appareil de commande suivant la revendication 1, **caractérisé en ce que** la structure de support (9, 109) de la plaquette de circuits imprimés est dimensionnée de telle manière que son contour extérieur entoure sensiblement de tous les côtés le contour extérieur de la plaquette de circuits imprimés flexible (5, 105).

3. Appareil de commande suivant la revendication 1 ou 2, **caractérisé en ce que** la structure de support (9, 109) de la plaquette de circuits imprimés comprend des parties détachables et/ou des parties (109a, 109b, 109c) s'étendant dans des plans différents.

4. Appareil de commande suivant l'une quelconque des revendications précédentes, **caractérisé en ce que** la structure de support (9, 109) de la plaquette de circuits imprimés est pourvue d'au moins une cavité (114) destinée à recevoir un composant électrique.

5. Appareil de commande suivant l'une quelconque des revendications précédentes, **caractérisé en ce que** la plaquette de circuits imprimés flexible (5, 105) est fixée dans des positions spécialement prédéfinissables sur la structure de support (9, 109) de la plaquette de circuits imprimés.

6. Appareil de commande suivant l'une quelconque des revendications précédentes, **caractérisé en ce que** la plaque de fond (2, 102) est en métal et est ancrée dans un creux ou une ouverture de la structure de support (9, 109) de la plaquette de circuits imprimés.

7. Appareil de commande suivant la revendication 6, **caractérisé en ce que** la plaque de fond métallique (2, 102) est surmoulée directement dans la structure de support (9, 109) de la plaquette de circuits imprimés, en plastique.
